# FASCICULE DE BREVET EUROPEEN

(11) **EP 0 443 967 B1**
(45) Date de publication et mention de la délivrance du brevet: **05.07.1995**
(21) Numéro de dépôt: 91420055.5
(22) Date de dépôt: 19.02.1991
(51) Int. Cl.: H05K 3/02, H01L 21/027

(54) **Procédé de lift-off mécanique d'une couche métallique sur un polymère**
Verfahren zur mechanischen Abhebung einer Metallschicht auf einem Polymer
Process for mechanical lift-off of a metal layer on a polymer

(30) Priorité: 23.02.1990 FR 9002690
(43) Date de publication de la demande: 28.08.1991
(73) Titulaire: FRANCE TELECOM, 75015 Paris (FR)
(72) Inventeur: Shiltz, André, F-38240 Meylan (FR); Palleau, Jean, F-38240 Meylan (FR); Torres, Joaquim, F-38950 Saint Martin le Vinoux (FR)
(74) Mandataire: de Beaumont, Michel

(56) Documents cités:
- EP-A- 0 025 261
- FR-A- 2 310 633
- US-A- 4 448 636
- US-A- 4 662 989
- US-A- 4 871 651
- PATENT ABSTRACTS OF JAPAN vol. 8, no. 228 (P-308)(1665) 19 octobre 1984,& JP-A-59 107354

## Description

La présente invention concerne un procédé dit de lift-off ou procédé d'enlèvement de couches par soulèvement appliqué au dépôt d'une couche métallique sur une couche de polymère diélectrique.

On connaît dans l'art antérieur des procédés de lift-off de type chimique qui consistent à retirer sélectivement une partie d'un dépôt obtenu par une méthode physique (pulvérisation ou évaporation) ou chimique (dépôt chimique en phase vapeur) en intercalant sous les zones que l'on veut éliminer une couche intermédiaire soluble dans un agent chimique.

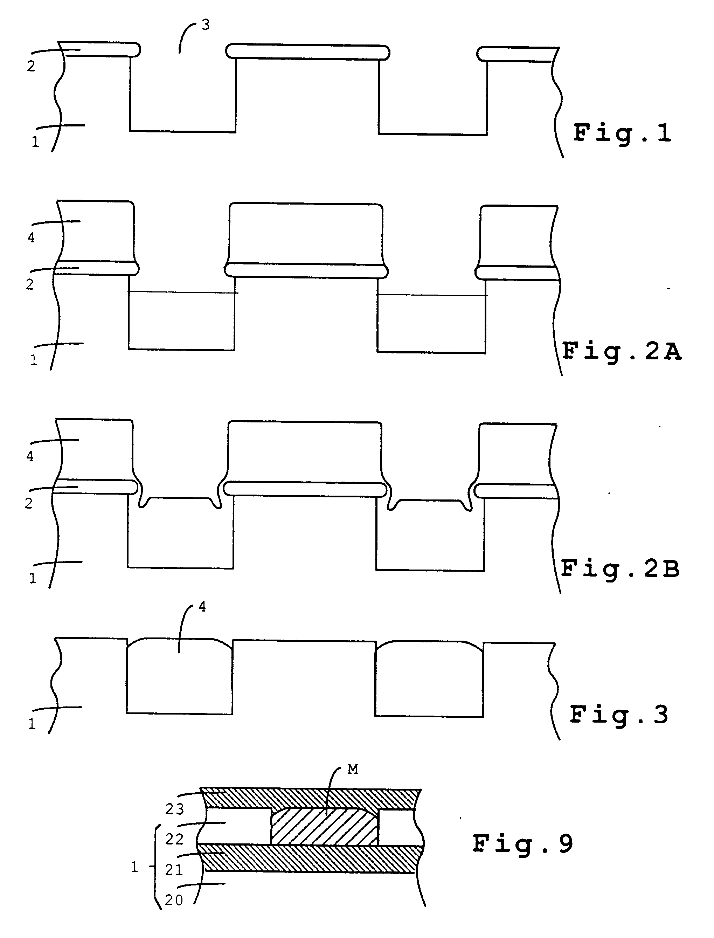

Certaines étapes du procédé classique de lift-off chimique sont illustrées en relation avec les figures 1 à 3 dans le cadre d'une application particulière où l'on veut remplir des tranchées formées dans un substrat.

On part d'un substrat 1 sur lequel on dépose une couche intermédiaire dite couche de lift-off ou de soulèvement 2. Ensuite, comme le représente la figure 1, on grave la couche 2 et l'on forme des tranchées 3 dans le substrat 1 de façon que des parties de la couche 2 restent en surplomb au-dessus des rainures 3.

A l'étape suivante, comme l'illustrent les figures 2A et 2B, on dépose le matériau, couramment un métal, 4 dont on veut remplir les rainures. Ce matériau est déposé par un procédé directif de façon qu'il croisse verticalement. L'exemple de la figure 2A correspond à un dépôt idéalement directif sans dépôt sur les parois verticales du motif. C'est par l'exemple ce qui se produit pour un dépôt formé par évaporation sous vide d'aluminium lorsque l'angle solide d'émission est suffisamment petit. La figure 2B correspond à un cas où la directivité est limitée ; c'est par exemple le cas d'un dépôt de cuivre par pulvérisation. Dans ce dernier cas, la tranche latérale de la couche intermédiaire 2 est partiellement recouverte. Pour se ramener au cas de la figure 2A, il faut prévoir une étape préalable de gravure non-directive qui élimine une partie superficielle du dépôt métallique.

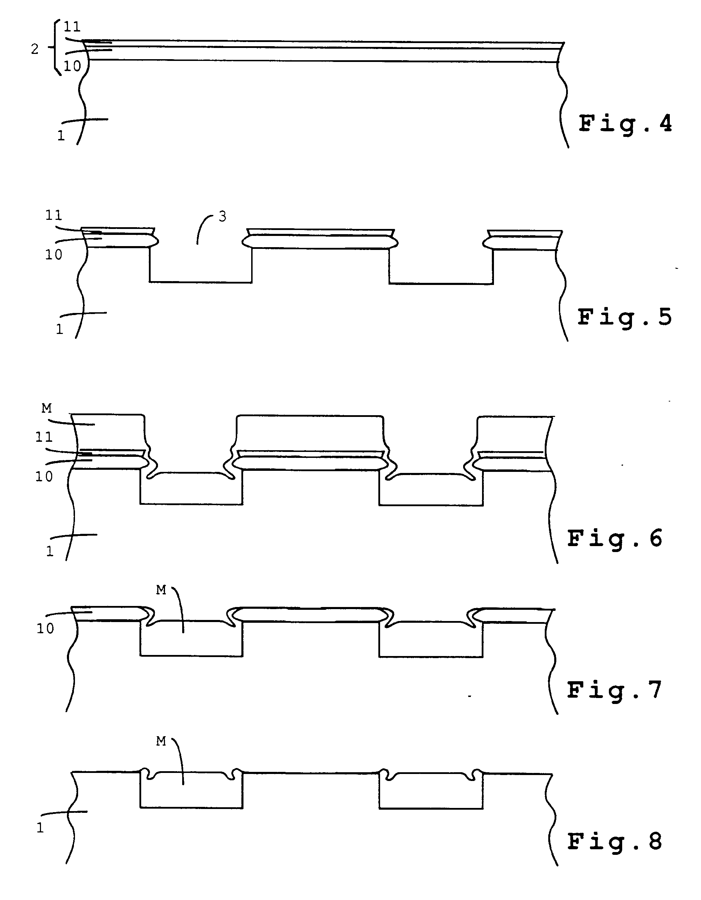

Enfin, on procède à une attaque par gravure chimique de la couche 2 qui est éliminée en entraînant le dépôt métallique qu'elle supportait. Pour cela il faut que les bords de la couche 2 soient apparents, comme dans le cas de la figure 2A. C'est pourquoi, dans le cas de la figure 2B, on prévoit une étape de gravure pour revenir au cas de la figure 2A. On arrive ainsi à la structure de la figure 3 dans laquelle les rainures 3 sont remplies de métal 4.

Ce procédé dit de lift-off chimique est couramment utilisé dans la fabrication des circuits intégrés mais présente un inconvénient majeur lié à la durée de l'opération dans le cas où les zones à éliminer occupent une grande surface.

La couche 2 peut être en polysiloxane. Dans ce cas, un bain d'acide fluorhydrique permet d'attaquer cette couche sous la couche métallique 4 à une vitesse de l'ordre de 10 micromètres par minute, c'est-à-dire un temps d'attaque de l'ordre de l'heure pour des zones à éliminer de l'ordre du millimètre carré, dimensions que l'on retrouve classiquement lors de la réalisation de réseaux d'interconnexions entre puces de circuits intégrés.

Pour éviter certains des inconvénients du procédé de lift-off chimique, le brevet US-A-4 871 651 propose un procédé de lift-off cryogénique dans lequel, comme l'indique la revendication 1 de ce brevet, on forme sur un substrat une couche d'un matériau de soulèvement, "le substrat ayant un coefficient de dilatation thermique différent de celui de cette couche", on grave la couche de soulèvement selon un motif choisi, on dépose un métal et on soumet l'ensemble "à une température suffisamment basse pour amener la couche de soulèvement à se détacher de la surface du substrat".

Comme l'indique les sous-revendications du brevet US-A-4 871 651, le substrat est de préférence un semiconducteur et la couche de soulèvement un produit photosensible. En effet, il est nécessaire que le substrat et la couche de soulèvement soient de natures distinctes pour présenter des coefficients de dilatation thermique nettement différents.

Par ailleurs, le brevet US-A-4 448 636 décrit un procédé de lift-off assisté par laser dans lequel un métal est déposé sur un substrat revêtu localement de polymère. Une irradiation par un faisceau laser provoque un dégazage du polymère à l'interface avec le métal et un décollement du métal. Ce processus qui se base sur une décomposition du polymère est complexe à mettre en oeuvre.

L'objet de la présente invention est de prévoir un procédé de lift-off simple à mettre en oeuvre dans le cas où le substrat est un polymère isolant, éventuellement muni de rainures que l'on veut remplir d'un métal. Dans ce cas, le procédé du brevet US-A-4 871 651 ne fonctionne pas, car les différences de coefficients de dilatation thermique entre un polymère, et les matériaux de soulèvement usuels (résines, résines photosensibles) sont trop faible.

Pour atteindre cet objet, la présente invention selon la revendication 1 prévoit un procédé de lift-off d'une portion d'une couche métallique dans lequel cette portion de couche métallique est formée sur un substrat de polymère diélectrique avec interposition d'une portion correspondante d'une couche intermédiaire, comprenant les étapes suivantes :
- sélectionner le matériau de la couche intermédiaire pour qu'il présente une interface à faible adhérence avec la couche métallique de sorte qu'une contrainte mécanique provoque un décollement du métal,
- appliquer à la structure une contrainte mécanique d'où il résulte un décollement au niveau de ladite interface,
- enlever chimiquement la couche intermédiaire.

Selon une variante de la présente invention selon la revendication 4, la couche intermédiaire est formée d'un sandwich de sous-couches telles que leur interface présente une faible adhérence de sorte qu'une contrainte mécanique provoque un décollement au niveau de ladite interface.

Selon un mode de réalisation de la présente invention, la contrainte mécanique résulte d'un choc thermique.

Selon un mode de réalisation de la présente invention, la couche intermédiaire est un polysiloxane, le substrat étant un polyimide.

Selon un mode de réalisation de la présente invention, la première sous-couche comprend un matériau tel qu'un polysiloxane, et la deuxième sous-couche comprend un métal, les matériaux des deux sous-couches présentant des coefficients de dilatation thermique distincts.

Selon un mode de réalisation de la présente invention, l'étape d'enlèvement mécanique comprend l'application d'un jet de fluide.

Selon un mode de réalisation de la présente invention, le choc thermique résulte d'un recuit suivi d'une trempe à température ambiante, ou, à l'inverse, d'une immersion dans de l'azote liquide suivie d'une remontée à température ambiante.

Ces objets, caractéristiques et avantages ainsi que d'autres de la présente invention seront exposés plus en détail dans la description suivante de modes de réalisation particuliers faite en relation avec les figures jointes parmi lesquelles :
les figures 1 à 3 ont été décrites précédemment dans le cadre de l'exposé de l'art antérieur et seront reconsidérées ci-après dans le cadre de la présente invention ;
les figures 4 à 8 illustrent une variante du procédé selon la présente invention ; et
la figure 9 illustre une application d'un procédé de lift-off.

Les étapes principales de la présente invention peuvent être décrites par les mêmes figures 1 à 3 que le procédé de lift-off chimique de l'art antérieur. L'invention diffère de l'art antérieur par le choix et le mode d'élimination de la couche intermédiaire 2, et concerne le cas où le substrat (ou la couche supérieure d'un ensemble formant substrat) est un polymère diélectrique.

Dans le cas d'un lift-off chimique, la couche intermédiaire 2 est choisie pour être attaquable chimiquement sélectivement par rapport au métal 4 et au substrat 1. Dans le cas du lift-off cryogénique, la couche intermédiaire est choisie pour présenter un coefficient de dilatation thermique distinct de celui du substrat. Selon la présente invention, on choisit une couche intermédiaire 2 qui présente la propriété d'avoir une interface à très faible adhérence avec la couche supérieure de métal 4 de sorte qu'une contrainte mécanique provoque un décollement du métal. Cette contrainte mécanique peut par exemple résulter d'un choc thermique. Ainsi, une fois réalisées les étapes conduisant à la structure de la figure 2A ou de la figure 2B, on pourra produire un choc thermique, ou bien par un recuit à haute température (quelques centaines de degrés) suivi d'une trempe à température ambiante ou bien à l'inverse par une trempe dans de l'azote liquide suivie d'une remontée jusqu'à la température ambiante. La contrainte mécanique due à la différence entre les coefficients de dilatation du métal 4 et de la couche intermédiaire provoque le décollement au niveau de l'interface faiblement adhérente. Ainsi, la partie de la couche 4 située au-dessus de la couche intermédiaire 2 est éliminée à la suite du choc thermique. Cette élimination peut être favorisée par projection d'un jet de fluide, par exemple de l'air comprimé.

On notera que ce procédé n'implique pas que les bords de la couche 2 soient apparents et l'on pourra procéder au choc thermique en partant d'une structure du type de celle de la figure 2B sans devoir effectuer de gravure complémentaire.

Ensuite, on élimine la couche intermédiaire 2 par une attaque chimique sélective qui est alors réalisée simultanément sur toute sa surface pour arriver comme dans l'art antérieur à la structure de la figure 3. Cette attaque s'effectuant perpendiculairement à la couche et non pas latéralement peut être rapide.

Ce procédé s'applique de façon générale à partir du moment où on a sélectionné une couche intermédiaire 2 telle que son adhérence avec la couche de métal 4 déposée ultérieurement est suffisamment faible pour qu'il se produise un décollement après application d'une contrainte mécanique telle que celle résultant d'un choc thermique. Des essais satisfaisants ont été réalisés par les inventeurs dans le cas où la couche de soulèvement était un polysiloxane et le métal du tungstène ou du cuivre.

Toutefois, il se peut que, pour certains métaux ou autres matériaux particuliers dont on veut réaliser l'élimination par lift-off, on ne connaisse pas de matériau facilement déposable susceptible de présenter une faible adhérence pour mettre en oeuvre le procédé selon la présente invention. Dans ce cas, on pourra, comme l'illustrent les figures 4 à 8, utiliser une couche intermédiaire composite constituée d'un empilement d'au moins deux sous-couches présentant entre elles une faible adhérence.

La figure 4 représente une étape initiale de mise en oeuvre de cette variante du procédé. Etant donné un substrat 1, la couche intermédiaire 2 comprend un sandwich dont la couche inférieure 10 est par exemple en polysiloxane et la couche supérieure 11 par exemple en cuivre.

A partir de ce sandwich, on forme, comme l'illustre la figure 5, les tranchées 3, une partie au moins du sandwich 10, 11 se trouvant en surplomb.

On procède alors au dépôt du métal M dont on veut remplir les tranchées 3. La figure 6 représente le cas, analogue à la figure 2B, où ce dépôt métallique n'est pas parfaitement directif et où les bords verticaux du sandwich 10, 11 sont partiellement recouverts.

On passe de l'état de la figure 6 à l'état de la figure 7 en appliquant un choc thermique selon l'invention. Il y a alors décollement de la couche 11 et du métal qui la recouvre par rapport à la couche 10 qui reste en place et qui est ensuite éliminée par attaque chimique comme le représente la figure 8.

La figure 9 illustre une utilisation classique du procédé de lift-off pour réaliser des communications (vias) entre lignes de connexion. La structure 1 correspond alors à un support 20 sur lequel ont été formées des bandes métalliques parallèles 21 recouvertes d'un isolant 22 tel qu'un polyimide. C'est cet isolant 22 qui constitue ce que l'on appelle ici le substrat. Les rainures 3 sont formées dans cet isolant et le métal M qui sert à remplir ces rainures a été déposé en utilisant le procédé selon la présente invention. Une deuxième couche de métallisation 23, en contact au niveau des vias par le métal M avec la couche métallique sous-jacente 21 est ensuite déposée et gravée en bandes, éventuellement en utilisant à nouveau le procédé selon l'invention.

Le procédé selon la présente invention a été décrit dans le cadre de l'application d'un choc thermique comme moyen d'application d'une contrainte mécanique pour décoller deux couches à faible adhérence. On pourrait utiliser d'autres moyens tels que la projection directe d'un jet de fluide, l'application d'ultrasons, ..., ou une combinaison de ces moyens.

## Revendications

1. Procédé de lift-off d'une portion d'une couche métallique (4,M) dans lequel cette portion de couche métallique est formée sur un substrat (1, 22) de polymère diélectrique avec interposition d'une portion correspondante d'une couche intermédiaire (2), le procédé comprenant les étapes suivantes :
- sélectionner le matériau de la couche intermédiaire pour qu'il présente une interface à faible adhérence avec la couche métallique de sorte qu'une contrainte mécanique provoque un décollement du métal,
- appliquer à la structure une contrainte mécanique d'où il résulte un décollement au niveau de ladite interface,
- enlever chimiquement la couche intermédiaire.

2. Procédé selon la revendication 1, caractérisé en ce que la contrainte mécanique résulte d'un choc thermique.

3. Procédé selon la revendication 2, caractérisé en ce que la couche intermédiaire est un polysiloxane, le substrat étant un polyimide.

4. Procédé de lift-off d'une portion d'une couche métallique (4,M) dans lequel cette portion de couche métallique est formée sur un substrat (1,22) de polymère diélectrique avec interposition d'une portion correspondante d'une couche intermédiaire (2), le procédé comprenant les étapes suivantes :
- former la couche intermédiaire (2) selon un sandwich de sous-couches (10, 11) telles que leur interface présente une faible adhérence de sorte qu'une contrainte mécanique provoque un décollement au niveau de ladite interface,
- appliquer à la structure une contrainte mécanique d'où il résulte un décollement au niveau de ladite interface,
- enlever chimiquement la sous-couche restante.

5. Procédé selon la revendication 4, caractérisé en ce que la contrainte mécanique résulte d'un choc thermique.

6. Procédé selon la revendication 4, caractérisé en ce que la première sous-couche comprend un matériau tel qu'un polysiloxane, et la deuxième sous-couche comprend un métal.

7. Procédé selon la revendication 5, caractérisé en ce que les matériaux des deux sous-couches présentent des coefficients de dilatation thermique distincts.

8. Procédé selon la revendication 1 ou 4, caractérisé en ce que l'étape d'enlèvement mécanique comprend l'application d'un jet de fluide.

9. Procédé selon l'une des revendications 2 ou 5, caractérisé en ce que le choc thermique résulte d'un recuit suivi d'une trempe à température ambiante.

10. Procédé selon l'une des revendications 2 ou 5, caractérisé en ce que le choc thermique résulte d'une immersion dans de l'azote liquide suivie d'une remontée à température ambiante.

## Patentansprüche

1. Verfahren zum Abheben eines Teiles einer Metallschicht (4, M), wobei dieser Teil der Metallschicht auf einem Substrat (1, 22) aus dielektrischem Polymer unter Zwischenschalten eines entsprechenden Teiles einer Zwischenschicht (2) aufgebracht ist und das Verfahren die folgenden Schritte aufweist:
- Auswählen des Materiales der Zwischenschicht, so daß es eine Grenzfläche mit geringer Haftung an der Metallschicht bildet, derart, daß eine mechanische Beanspruchung ein Abheben des Metalls auslöst,
- Ausüben einer mechanischen Beanspruchung auf die Struktur, woraus ein Abheben auf dem Niveau der besagten Grenzfläche resultiert,
- chemisches Entfernen der Zwischenschicht.

2. Verfahren nach Anspruch 1, dadurch gekennzeichnet, daß die mechanische Beanspruchung von einem thermischen Schock herrührt.

3. Verfahren nach Anspruch 2, dadurch gekennzeichnet, daß die Zwischenschicht ein Polysiloxan und das Substrat ein Polyimid ist.

4. Verfahren zum Abheben eines Teiles einer Metallschicht (4, M), wobei dieser Teil der Metallschicht auf einem Substrat (1, 22) aus dielektrischem Polymer unter Zwischenschalten eines entsprechenden Teiles einer Zwischenschicht (2) aufgebracht ist und das Verfahren die folgenden Schritte aufweist:
- Ausbilden der Zwischenschicht (2) entsprechend einem Sandwich aus solchen Unterschichten (10, 11), daß ihre Grenzfläche eine geringe Haftung aufweist, so daß eine mechanische Beanspruchung ein Abheben auf dem Niveau der besagten Grenzfläche auslöst,
- Ausüben einer mechanischen Beanspruchung auf die Struktur, woraus ein Abheben auf dem Niveau der besagten Grenzfläche resultiert,
- chemisches Entfernen der Zwischenschicht.

5. Verfahren nach Anspruch 4, dadurch gekennzeichnet, daß die mechanische Beanspruchung von einem thermischen Schock herrührt.

6. Verfahren nach Anspruch 4, dadurch gekennzeichnet, daß die erste Unterschicht ein Material wie z.B. Polysiloxan und die zweite Unterschicht ein Metall aufweist.

7. Verfahren nach Anspruch 5, dadurch gekennzeichnet, daß die Materialien der zwei Unterschichten unterschiedliche thermische Ausdehnungskoeffizienten aufweisen.

8. Verfahren nach Anspruch 1 oder 4, dadurch gekennzeichnet, daß der Schritt des mechanischen Abhebens die Anwendung eines Fluidstrahles umfaßt.

9. Verfahren nach einem der Ansprüche 2 oder 5, dadurch gekennzeichnet, daß der thermische Schock von einem Glühen mit anschließendem Abkühlen auf Umgebungstemperatur herrührt.

10. Verfahren nach einem der Ansprüche 2 oder 5, dadurch gekennzeichnet, daß der thermische Schock von einem Eintauchen in flüssigen Stickstoff mit anschließendem Erwärmen auf Umgebungstemperatur herrührt.

## Claims

1. A lift-off process for removing a metal layer portion (4, M) wherein said metal layer portion is formed on a dielectric polymer substrate (1, 22) with intercalation of a corresponding portion of an intermediate layer (2), comprising the following steps:
- selecting the material of said intermediate layer to have a low adhesive interface with the metal layer so that a mechanical stress causes detachment of the metal,
- applying to the structure a mechanical stress causing detachment of said metal at said interface,
- chemically removing said intermediate layer.

2. A lift-off process according to claim 1, characterized in that said mechanical stress results from a thermal shock.

3. A process according to claim 2, characterized in that said intermediate layer is a polysiloxane, the substrate being a polyimide.

4. A lift-off process for removing a metal layer portion (4, M) wherein said portion of metal layer is formed on a substrate (1, 22) of a dielectric polymer with intercalation of a corresponding portion of an intermediate layer (2), comprising the following steps:
- forming said intermediate layer (2) according to a sandwich of sublayers (10,11) such that their interface has a low adherence so that a mechanical stress causes detachment at said interface,
- applying to the structure a mechanical stress, which results in detachment at said interface,
- chemically removing the remaining sublayer.

5. A process according to claim 4, characterized in that the mechanical stress results from a thermal shock.

6. A process according to claim 4, characterized in that the first sublayer comprises a material such as a polysiloxane and the second sublayer comprises a metal.

7. A process according to claim 5, characterized in that the materials of the two sublayers have distinct thermal expansion coefficients.

8. A process according to claim 1 or 4, characterized in that the mechanical removal step comprises the application of a jet of fluid.

9. A process according to claim 2 or 5, characterized in that the thermal shock results from annealing followed by cooling down to ambient temperature.

10. A process according to claim 2 or 5, characterized in that the thermal shock results from immersion in liquid nitrogen followed by warming up to ambient temperature.
